# EUROPEAN PATENT APPLICATION

(11) **EP 0 849 771 A1**
(43) Date of publication of application: **24.06.1998**
(21) Application number: 96402820.3
(22) Date of filing: 19.12.1996
(51) Int. Cl.: H01L 21/00, H01L 21/8248, H01L 27/06

(54) **Method of forming a depletion jfet and method of forming a depletion jfet and a bipolar transistor on a semiconductor substrate**

(71) Applicant: MOTOROLA SEMICONDUCTEURS S.A., F-31023 Toulouse Cédex (FR)
(72) Inventor: Ducasse, Jean-Paul, 31830 Plaisance Du Touch (FR); Capilla, Jose, 31170 Tournefeuille (FR); Segart, Pascal, 31600 Seysses (FR)
(74) Representative: Joly, Jean-Jacques

(57) **Abstract**

A method of forming a depletion JFET comprises the steps of defining the drain (52), source (50) and isolation (48) regions at the same time using a master mask, and next forming first an isolation region (48) and then the source (50) and drain (52) regions in a semiconductor region (10). A gate contact region (58) is then formed in the semiconductor region adjacent at least one of the source and drain regions and then a top gate region (59) is formed in the semiconductor region adjacent a top surface of the semiconductor region and such that it extends over the drain (52) and source (50) regions and the gate contact region (58). A channel region (57) is then formed buried in the semiconductor region such that it extends between the source (50) and drain (52) regions. A method of forming a depletion JFET and a bipolar transistor on a semiconductor substrate is also disclosed.

## Description

### Field of the Invention

This invention relates to a method of forming a depletion Junction Field Effect Transistor (JFET) and a method of forming a depletion JFET and bipolar transistor on a semiconductor substrate.

### Background of the Invention

The proliferation of battery powered products has driven a need to develop low voltage linear circuits; that is, linear circuits that operate with voltages as low as 1 volt.

In order to realise such low voltage circuits, in the past depletion mode FETs have been used since depletion FETs can operate typically at voltages in the region of 1 volt whereas enhancement mode devices can only operate down to about 3 volts. Many manufacturers have utilised CMOS technologies to form depletion MOSFETs, since CMOS has low input current and low transconductance which allows much higher slew rate for a given gain-bandwidth product than bipolar transistors. However, CMOS depletion devices are typically expensive to manufacture as they generally require complicated process steps. Compared to bipolar devices, CMOS devices suffer from a further disadvantage in that CMOS devices have a lower output current capability, provide greater noise and higher offsets than bipolar transistors.

As with depletion MOSFETS, Junction Field Effect Transistors (JFETs) can operate in both the enchancement mode and the depletion mode depending on the gate-to-source voltage. Furthermore, as depletion JFETs conduct current for a gate-to-source voltage of zero volt, the depletion JFET can also be used in designing low voltage linear circuits operating with voltages as low as 1 volt and even down to approximately 0.8 volt at room temperature.

Depletion JFETs have an advantage over depletion MOSFETs in that they are generally simpler to manufacture. However, JFETs are known to be sensitive to outside contamination and so, in the known JFET manufacturing processes, special process steps are still required to avoid contamination which could lead to unstable JFET electrical parameters. In addition, with the known processes the source, drain and isolation regions are formed using separate masks. This means that the size of the JFET has to be dimensioned in order to take account of alignment tolerances, which has the effect of increasing the size of the JFET.

US patent no. 5,376,565 discloses a process for forming a lateral bipolar transistor wherein openings for forming a current electrode region, a base region and an isolation region are all formed simultaneously so that they are automatically self-aligned. However, this document only describes a process for forming lateral bipolar transistors.

Low voltage linear circuits having amplifiers operating with voltages as low as 3 volts further require a rail-to-rail architecture. This can be achieved by complicated designs or by fabricating a depletion FET that allows such a feature to be achieved.

There is therefore a need to provide an improved process for forming a depletion JFET device.

### Summary of the Invention

In accordance with a first aspect of the present invention there is provided a method of forming a depletion JFET as recited in claim 1 of the accompanying claims.

In accordance with a second aspect of the present invention there is provided a method of forming a depletion JFET and a bipolar transistor on a semiconductor substrate as recited in claim 9 of the accompanying claims.

### Brief Description of the Drawings

A method of forming a depletion JFET and a method of forming a bipolar transistor and a depletion JFET on a semiconductor substrate in accordance with preferred embodiments of the present invention will now be described, by way of example only, with reference to the accompanying drawings in which::
FIG. 1 is an enlarged, schematic cross-sectional view of a depletion JFET formed by a method in accordance with a preferred embodiment of the present invention;

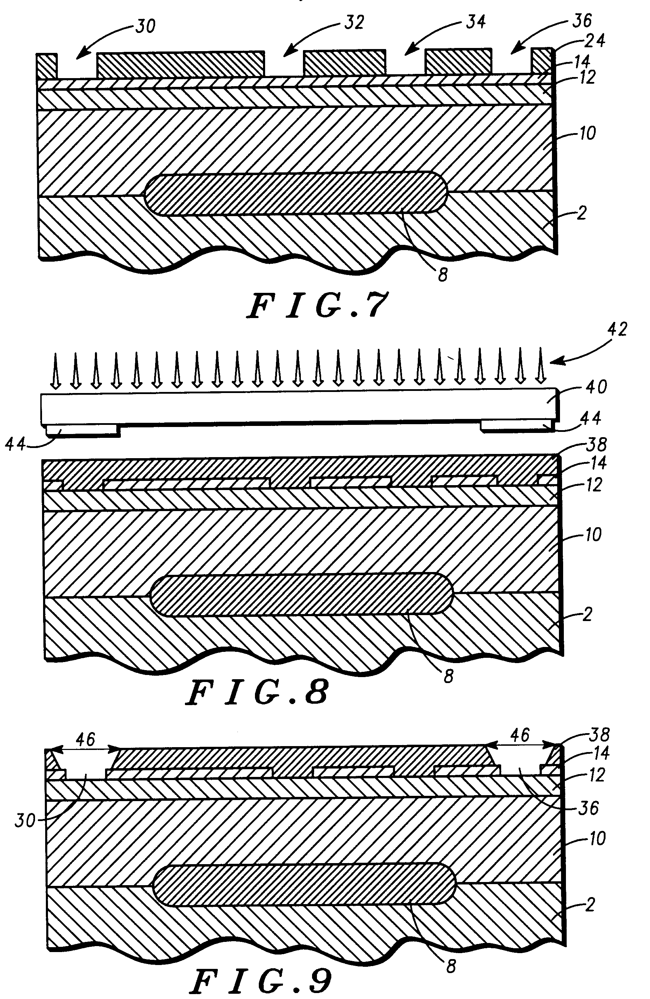

FIGs. 2-23 are enlarged, schematic cross-sectional views of the JFET of FIG. 1 in various stages of fabrication using the method in accordance with the present invention;
FIG. 24 is a schematic top plan view of a depletion JFET and bipolar transistor integrated on a substrate using a method in accordance with a preferred embodiment of the invention;
FIG. 25 is a schematic representation of a master mask used for forming the integrated JFET and bipolar transistor of FIG. 24; and
FIG. 26 is a schematic representation of a oversize isolation mask for use in the method of forming a bipolar transistor and JFET in accordance with the preferred embodiment of the present invention.

### Detailed Description of the Drawings

A method of forming a depletion JFET in accordance with a preferred embodiment of the present invention will now be described with reference to forming a P-channel depletion JFET. In the following description therefore certain regions and layers will be described as being formed from certain materials and having a certain conductivity type. It will however be appreciated that this is for illustrative purposes only and that it is not intended that the invention be limited to the specific types of material, conductivity types and doping levels of the preferred embodiment described hereafter.

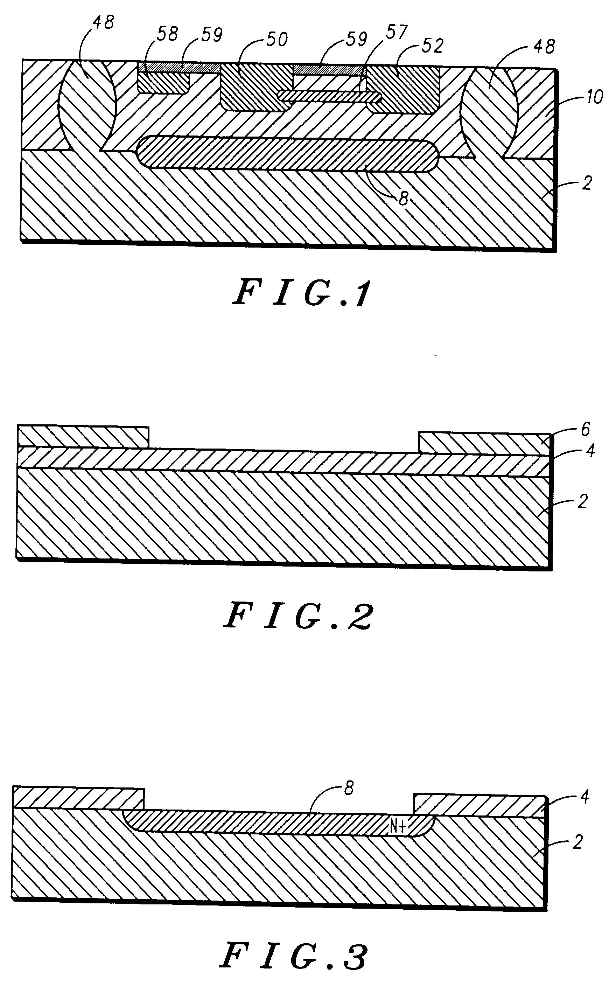

Referring firstly to FIG. 1, a depletion JFET formed by a method in accordance with the present invention comprises a semiconductor substrate 2 a buried region 8, isolation regions 48 formed in a semiconductor region 10, which preferably is an epitaxial layer 10, source 50 and drain 52 regions and a gate contact region 58 formed between one of the source 50 and drain 52 regions and an isolation region 48. A channel region 57, formed buried in the epitaxial layer 10, extends between the source 50 and 52 regions and a top gate region 59, formed at the surface of the epitaxial layer 10, extends over the channel region 57, and substantially the gate contact region 58, and the source 50 and drain 52 regions.

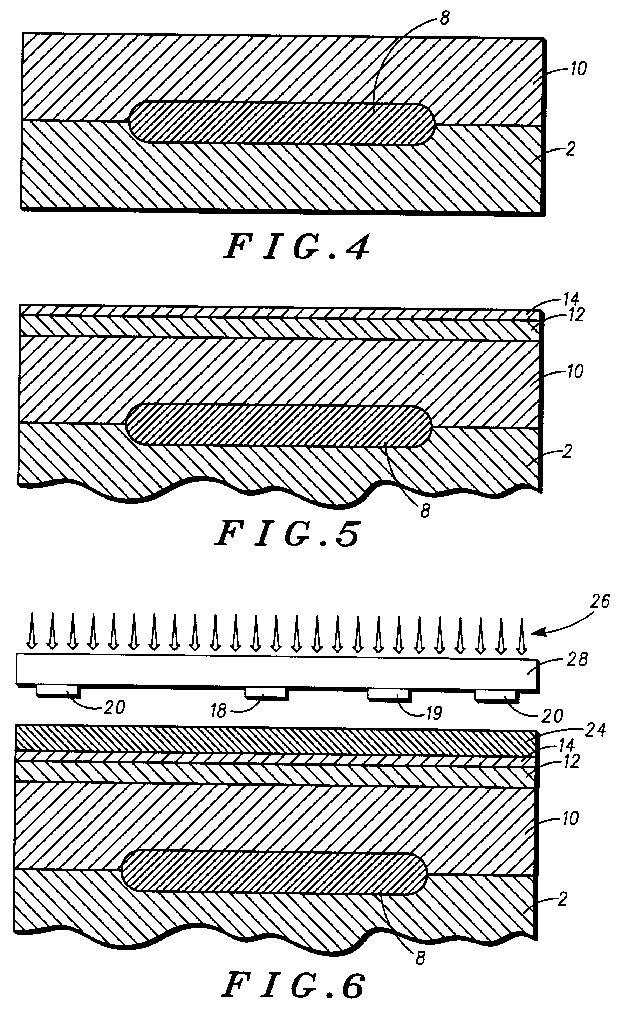

Referring now also to FIG. 2, a masking layer 4, such as a layer of silicon oxide, is formed on a P-type, 〈111〉, silicon substrate 2. The silicon oxide layer 4 is patterned and etched using a patterned photoresist layer 6 as a mask to provide an opening in the silicon oxide layer 4 to the substrate 2. The photoresist layer 6 is then removed. A N+ conductive region 8 is then formed in the substrate by first depositing by spin-on a solution of arsenic and by then diffusing the arsenic into the substrate in a furnace (FIG. 3). The silicon oxide layer 4 is then removed and an epitaxial layer 10 of N conductivity type is grown so that the N+ region forms a N+ buried region 8 as shown in FIG. 4.

With reference to FIG.5, after growth of a silicon oxide layer 12 (or insulating layer) formed by thermal oxidation of the N-type epitaxial layer 10, a silicon nitride layer 14 is deposited for patterning.

A negative photoresist layer 24 is deposited on the silicon nitride layer 14 (FIG. (6). The negative photoresist layer 24 is exposed to UV light 26 through an optical master mask 28. Optical master mask 28 comprises patterns 20, 18, 19 which correspond to the isolation, drain and source regions respectively of the JFET which are to be formed in the epitaxial layer 10. As these patterns 18-20 are defined at the same time, they are self-aligned.

In FIG. 7, the photoresist layer 24 protected by the patterns from the optical mask 28 is removed to form openings 30-36 in the photoresist layer 24 extending to the silicon nitride layer. The silicon nitride layer 14 is then dry etched to extend the openings 30-36 to the silicon oxide layer 12. The photoresist layer 24 is then removed. The silicon nitride layer 14 acts as a masking layer for further process steps.

Another negative photoresist layer 38 is deposited over the silicon nitride layer 14 and openings 30-36 and exposed to UV light 42 through an optical oversize isolation mask 40 having patterns 44 for an oversize isolation mask (FIG. 8). As shown in FIG. 9, each opening 46 formed in the photoresist layer 38 by the oversize isolation mask patterns 44 is greater than the respective opening 30, 36 in the silicon nitride layer 14.

An etching operation then takes place to remove the photoresist layer 38 and to wet etch the silicon oxide layer 12 up to the epitaxial layer 10 inside the openings 30, 36 defined in the silicon nitride layer 14.

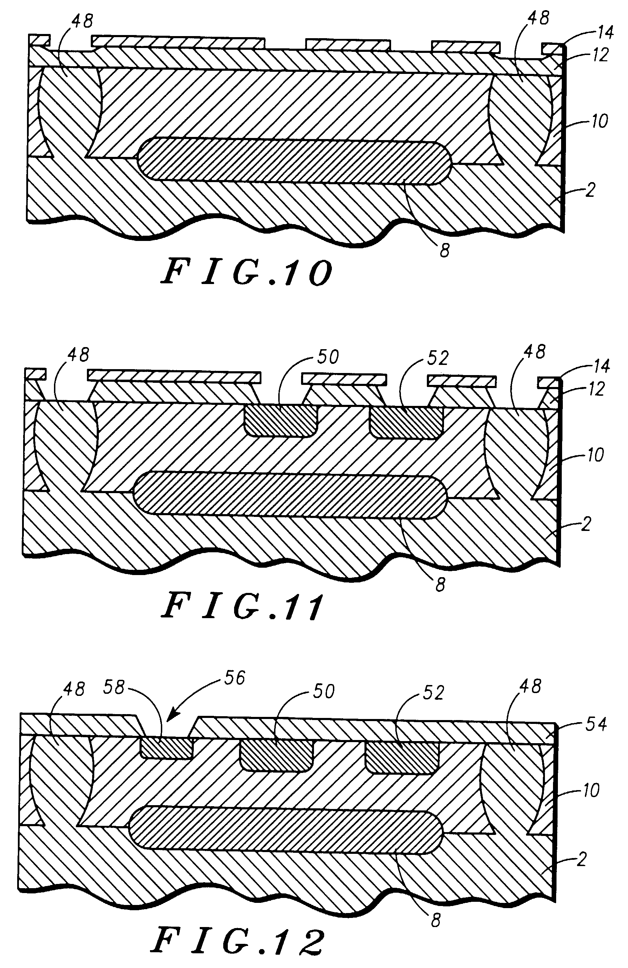

Referring now also to FIG. 10, a B2O3 solution containing boron is then coated by spin-on on the entire wafer. The wafer is then placed in a high temperature furnace so that the boron diffuses into the silicon to form a P-type isolation region 48 in the epitaxial layer 10. Only two isolation regions 48 are shown for simplicity. During the high temperature phase, the silicon oxide 12 grows over the P-type isolation regions 48.

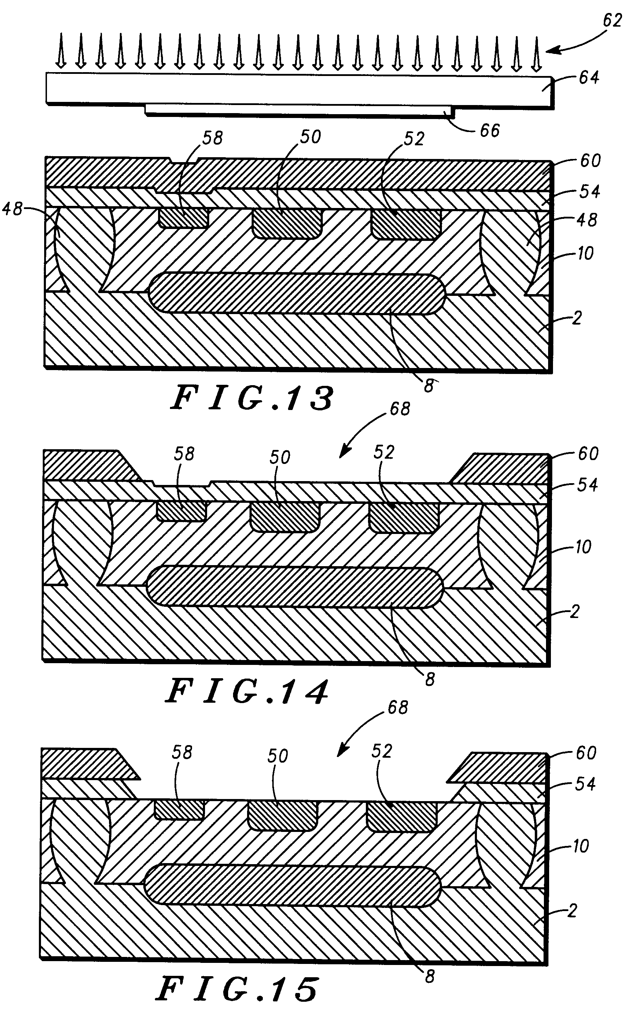

In FIG. 11, after isolation diffusion, the portions of silicon oxide layer 12 beneath the openings 30-36 in the silicon nitride layer 14 are wet etched to extend the openings to the P-type isolation regions 48 and the epitaxial layer 10. A screen oxide is then grown in the openings of the silicon oxide layer 12. P-type regions 50, 52 are then formed by implanting boron into the epitaxial layer 10 and the wafer is then annealed. Boron is also implanted into the P-type isolation regions 48. The P regions 50, 52 form the source and drain regions respectively of the JFET in accordance with the present invention.

The silicon oxide layer 12 and the silicon nitride layer 14 are then removed and a further insulating layer 54, such as a 0.35 micron (3500 Angstrom) thick oxide layer, is formed over the epitaxial layer 10.

In order to form a heavily doped N-type contact to the epitaxial layer 10 for the JFET, an opening 56 is formed in the silicon oxide layer 54 extending to the epitaxial layer 10 between an isolation region 48 and one of the source 50 and drain 52 regions (FIG. 12). A N+ gate contact region 58 is then formed in the epitaxial layer 10 through the opening 56. The N+ region 58 is formed by placing the wafer in a furnace with a phosphine gas followed by an annealing step and an oxidation step. The silicon oxide layer 54 is thus approximately 0.33 microns (3300 Angstroms) thick substantially filling the opening 56. Over the rest of the wafer, the silicon oxide layer 54 has a thickness of 0.55 microns (5500 Angstroms).

Next, the surface of the silicon oxide layer 54 is heavily N-type doped due to the high doping level of the N-type region 58, around 1E20 at/cm³ at the surface, which level is required to form the N-type gate contact region 58 to the epitaxial layer 10. In order to avoid a N-type surface contamination of the top gate region 59 of the JFET (see FIG. 1), a portion 0.15 microns (1500 Angstroms) thick of the silicon oxide layer 54 is removed by partial wet etching.

In FIG. 13, a negative photoresist layer 60 is then coated by spin-on on the entire surface of the wafer, exposed to UV light 62 of an alignment machine (not shown) through an optical mask 64 with top gate pattern 66. In FIG. 14, the patterned photoresist layer 60 is then used to form an opening 68 for the top gate region 59 of the JFET. The silicon oxide layer 54 beneath the opening 68 is then chemically etched to the surface of the epitaxial layer 10, FIG. 15. The photoresist layer 60 is then removed.

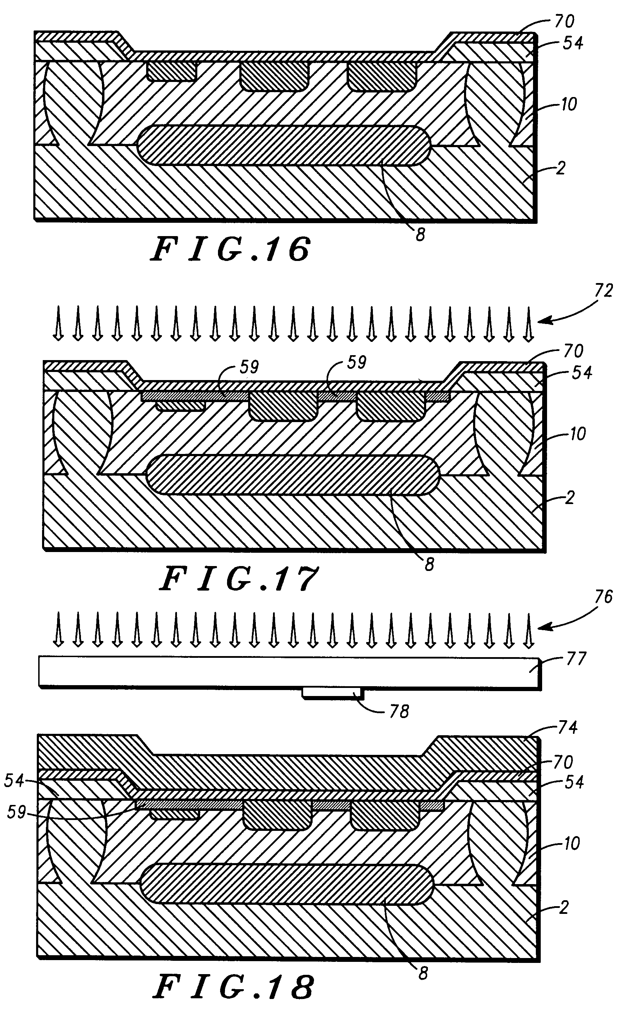

An additional insulating layer 70, preferably a TetraEthyl OrthoSilicate (TEOS) layer having a thickness of 0.06 microns (600 Angstroms) is deposited on the wafer (FIG. 16) in a furnace at a temperature of approximately 725 ºC. This step of depositing a TEOS layer 70 is a critical step for the reliability of the JFET since at the start of deposition (see FIG. 15) the silicon in opening 68 is uncovered. The uncovered area of the epitaxial layer 10 has a doping level around 8E15 at/cm³ and thus is very sensitive to the slightest outside contamination source and especially to the heavily N-type doped surface of the silicon oxide layer 54. The uncovered silicon of the epitaxial layer 10 which forms the top gate region 59 of the JFET could be N-type contaminated if no specific care were to be taken leading to unstable electrical JFET parameters, such as drain-to-source breakdown voltage or pinch-off voltage. For this reason, the silicon oxide layer 54 is partially removed by for example wet etching to remove the contaminating N-type doped oxide layer.

In FIG. 17, the top gate region 59 of the JFET is formed by implanting N-type impurities 72, preferably using an arsenic source, a dose of 1.2E12 at/cm² and energy of 170KeV, into the wafer through the TEOS layer 70 in the area defined by the opening 68 patterned in the silicon oxide layer 54. Outside this area the field oxide defined by the grown silicon oxide layer 54 and the TEOS layer 70 is sufficiently thick, approximately 0.465 microns (0.465 microns = 0.55 - 0.15 (wet etch) + 0.065 (TEOS)), to block the ion beam for the energy given above. The doping level of the arsenic-doped top gate region 59 is lower than that of the P-type source 50 and drain 52 regions so that the respective doping concentrations are not inverted. In order that, in operation, the channel region 57 may be completely depleted, the top gate region 59 should extend completely over the channel region 57 and overlap the source 50 and drain 52 regions.

Arsenic is preferably implanted through the TEOS layer 70 in order to cancel the channelling effect and so improve the doping concentration profile and consequently the electrical characteristics of the JFET.

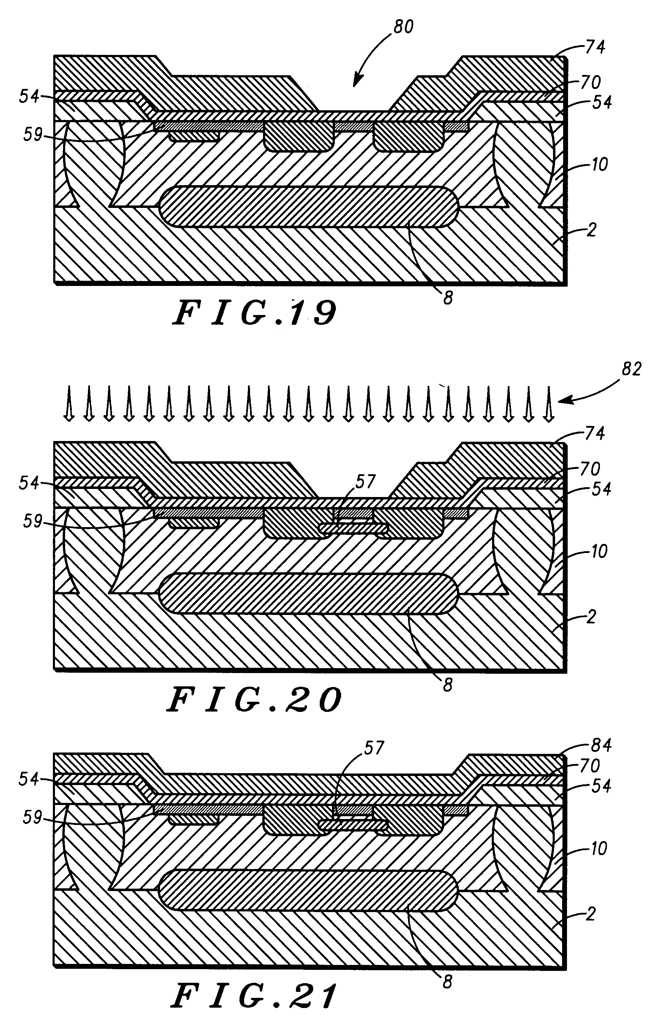

A negative photoresist or masking layer 74 is coated by spin-on on the entire surface of the wafer, exposed to UV light 76 of an alignment machine (not shown) through an optical channel mask 77 including a channel pattern 78 (FIG. 18) and then patterned and etched to provide an opening 80 formed in the photoresist layer 74 and extending to the TEOS layer 70 (FIG. 19).

Referring now to FIG. 20, a P-type impurity 82 is then implanted through the TEOS layer 70 in the opening 80 to form the channel region 57 of the JFET. Preferably, a boron source is used with a dose of 1.3E12 at/cm² and an energy of 110KeV. The opening 80 defines the width of the channel region 57 whereas the length is defined by the distance between the source 50 and drain 52 regions.

Boron is preferably implanted through the TEOS layer 70 in order to cancel the channelling effect and so improve the doping concentration profile and consequently the electrical characteristics of the JFET.

The photoresist layer 74 is then removed and a layer 84 of phosphorous doped TEOS is deposited on the TEOS layer 70 having a thickness of approximately 0.2 microns (2000 Angstrom). The phosphorous in this layer 84 (approximately 2.5%) has a gettering effect. It traps the mobile charges far from the silicon-to-silicon oxide interface. The result is a JFET having very stable behaviour.

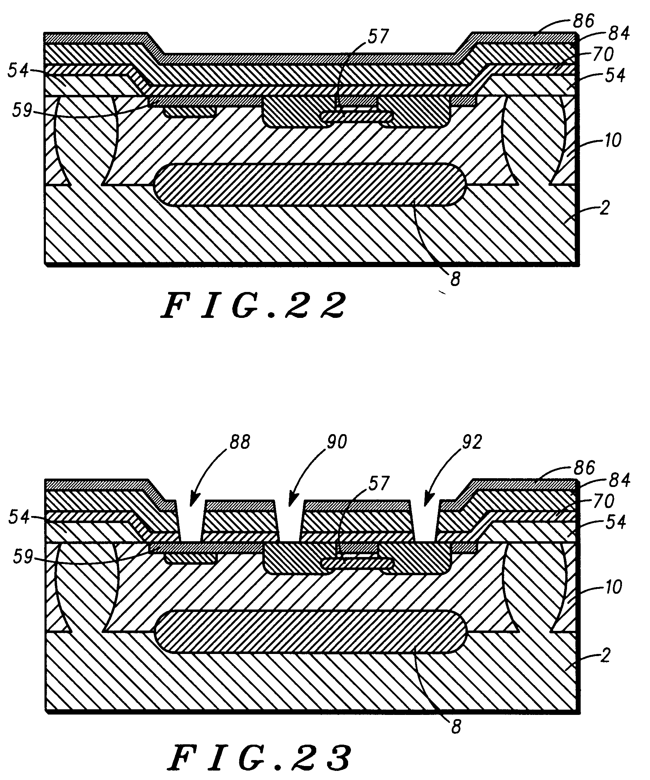

In FIG. 22, a passivation layer 86, preferably a silicon nitride layer having a thickness of 0.125 microns (1250 Angstrom), is deposited on the wafer. Preferably, the nitride layer 86 is deposited in a furnace (not shown) at a temperature which is sufficiently high to anneal the arsenic and boron implants of the top gate region 59 and channel region 57, respectively. Preferably, the temperature is approximately 740 ºC. Since annealing can be achieved at the same time as the formation of the nitride layer 86, there is therefore no need for an additional high temperature process for annealing both the arsenic and boron implants that would drastically influence the electrical characteristics of the device.

Contact openings 88, 90, 92 are then formed in the nitride layer 86, both TEOS layers 84, 70 to the epitaxial layer 10 so that contacts to the gate, source and drain respectively can be formed (FIG. 23). Preferably, the contact openings 88, 90, 92 are dry etched.

The above described method only requires one additional mask, namely the channel mask 77, in order to form a depletion JFET compared to at least four required to form a depletion PMOS.

By partially removing the top portion of the silicon oxide layer 54, the present invention reduces the likelihood of N-type contamination of the top gate region 59 without complicated process steps.

It will be understood that although the invention has been described with respect to one drain, one source and one gate contact region, in practice a very large number of regions will be formed in the epitaxial layer 10. By ensuring both source and drain regions are self-aligned with the isolation regions, the present invention eliminates the alignment tolerances between these two layers and therefore saves space and minimises device parasitics. The device can also be designed smaller and consequently at a lower price.

An advantage of the method of forming a depletion JFET in accordance with the present invention is that the above steps can be readily combined with steps for forming a bipolar device, such as those described in US patent no. 5,376,565, to thereby provide a method of forming a depletion JFET combined with a bipolar transistor on a semiconductor substrate.

The steps of the method disclosed in US patent no. 5,376,565 may be combined with the method in accordance with the invention in the following manner. In the following description, a P-type depletion JFET is integrated with a NPN bipolar transistor. However, it will be appreciated that this is for illustrative purposes only and that it is not intended for the invention to be limited to the specific conductivity types mentioned below.

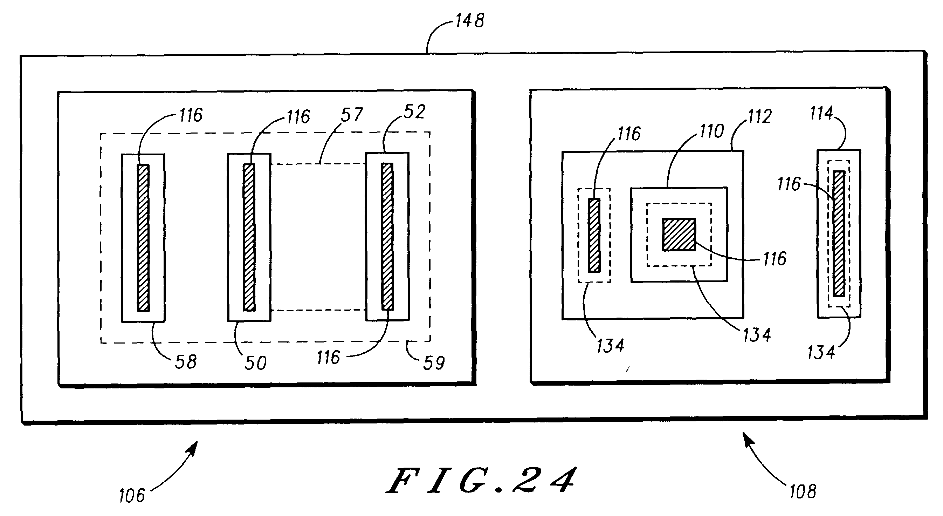

FIG. 24 shows a JFET 106 integrated with a NPN bipolar transistor 108. The JFET 106 formed in accordance with the present invention comprises source 50, and drain 52 regions, a gate contact region 58, a channel region 57 and a top gate region 59. The bipolar transistor 108 comprises an emitter region 110, a base region 112 and a collector region 114. FIG. 24 also shows the contacts 116 to the respective regions and the isolation 148, which isolation includes the isolation regions 48.

The pattern for the base region 112 of the NPN bipolar transistor is formed at the same time as the patterns for the drain 52 and source 50 regions and isolation regions 48 of the JFET. The patterns for the emitter 110 and collector 114 regions are formed at the same time as the pattern for the gate contact region 58 of the JFET. An optical master mask 128 for forming a depletion JFET and a bipolar device therefore comprises patterns 20, 18, 19 which correspond to the isolation, drain and source regions respectively of the JFET and additional pattern 132 which corresponds to the base region 112 (see FIG. 25). As the patterns are defined at the same time as the isolation on the master mask 128, they are all self-aligned to the isolation 148. This allows for a significant reduction in the dimensions of the finished device.

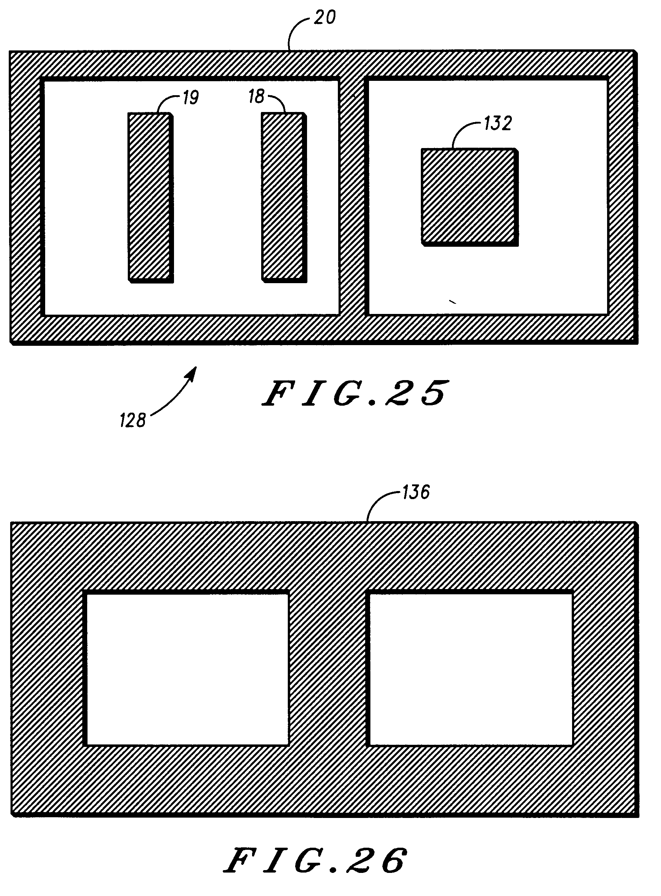

The oversize isolation mask 136, shown in FIG. 26, is only used for etching the oxide layer 12 (mask 40 of FIG. 7) for forming the isolation regions 48 (FIG. 8).

The N-type emitter region 110 and N-type collector region 114 of the bipolar transistor 108 are formed during the same diffusion step as the N-type gate contact region 58. The P-type base region 112 is formed at the same time as the source 50 and drain 52 regions are formed.

At the same time as the negative photoresist layer 60 is patterned using the optical mask 64 with oversize contact patterns 66 to form an opening for the top gate region 59 of the JFET (FIG. 13 above), the photoresist layer 60 is also patterned for the oversize contacts of the bipolar transistors 134 and maybe other passive devices to be integrated with the JFET 106 and bipolar transistor 108.

The top gate region 59 of the JFET is then formed as described above.

As mentioned above, the annealing of the arsenic and boron implants of the top gate region 59 and channel region 57 respectively can be achieved at the same time as the formation of the nitride layer 86. There is therefore no need for an additional high temperature process for annealing both the arsenic and boron implants that would drastically influence the electrical characteristics of the bipolar transistor.

Thus, the method in accordance with the present invention provides a self-aligned depletion JFET without the need for a complicated process with many masks, and thus provides a cost-effective method of forming devices for low voltage applications. The method in accordance with the invention has a further advantage in that it is substantially aligned with a bipolar technology, enabling JFETs and bipolar devices to be integrated in the same substrate without the need for many additional complex process steps. The integration of the JFET with the bipolar process requires only one additional mask for the channel.

The buried region 8 is optional but helps to reduce the series resistance between the back gate region which is formed in the epitaxial layer 10 between the source 50 and drain 52 regions and to disable the parasitic substrate PNP transistor formed by the source region 50, the epitaxial layer 10 and the substrate 2. When a bipolar transistor is integrated with the JFET, the buried region 8 also helps to disable the parasitic substrate PNP formed by the emitter, base and collector regions of the bipolar transistor.

## Claims

1. A method of forming a depletion JFET comprising the steps of:
providing a semiconductor substrate (2) having a semiconductor region (10) of a first conductivity type formed over the semiconductor substrate;
forming a masking layer (14) over the semiconductor region (10);
patterning and etching the masking layer (14) to form openings (30-36) in the masking layer, the openings for defining the drain (52) and source (50) and isolation regions (48) of the JFET;
forming an isolation region (48) and then forming the source (50) and drain (52) regions of a second conductivity type in the semiconductor region through the openings;
removing the masking layer (14) and forming a first insulating layer (54) over the semiconductor region;
patterning and etching the first insulating layer to form a first opening (56) in the first insulating layer extending to the semiconductor region;
forming through the first opening a gate contact region (58) of the first conductivity type in the semiconductor region (10) adjacent at least one of the source and drain regions;
removing a portion of the first insulating layer;
patterning and etching the remaining portion of the first insulating layer to form a second opening (68) in the first insulating layer to the semiconductor region which extends over the drain (52) and source (50) regions and the gate contact region (58);
forming a top gate region (59) of the first conductivity type in the semiconductor region adjacent a top surface of the semiconductor region through the second opening (68) in the first insulating layer;
forming a channel region (57) of the second conductivity type buried in the semiconductor region, the channel region extending between the source (50) and drain (52) regions; and
forming metal contacts to the source and drain regions and gate contact region.

2. The method according to claim 1, wherein the step of removing a portion of the first insulating layer comprises the step of performing a wet etch.

3. The method according to claim 1 or 2, wherein the step of forming the top gate region (59) comprises:
forming a second insulating layer (70) over the first insulating layer and an area of the epitaxial region defined by the second opening (68); and
implanting a dopant of the first conductivity type through the second insulating layer into the area of the epitaxial region to form the top gate region (59).

4. A method according to claim 3, wherein the step of forming a channel region (57) comprises:
forming a masking layer (74) over the second insulating layer (70);
patterning and etching the masking layer to provide an opening (80) in the masking layer extending to the second insulating layer substantially over the source (50) and drain (52) regions;
implanting a dopant of the second conductivity type through the second insulating layer into an area of the epitaxial region defined by the opening in the masking layer to form the channel region (57); and
removing the masking layer (74).

5. A method according to claim 4, further comprising, after the step of removing the masking layer (74), the steps of:
forming a third insulating layer (84) on the second insulating layer (70); and
depositing a passivation layer (86) on the third insulating layer at a temperature which is high enough to anneal the channel region and top gate region.

6. A method according to claim 3, 4 or 5, wherein the second insulating layer (70) comprises a TEOS layer.

7. A method according to any preceding claim wherein the step of providing a semiconductor substrate (10) comprises the steps of:
providing a semiconductor substrate (2) of the second conductivity type;
forming a masking layer (4) over the semiconductor substrate;
patterning and etching the masking layer to form an opening therein extending to the semiconductor substrate;
forming a conductive region (8) of the first conductivity type in the semiconductor substrate through the opening;
removing the masking layer (4); and
growing the semiconductor region (10) over the semiconductor substrate (2) such that the semiconductor region (10) is formed over the semiconductor substrate (2) and the conductive region (8) forms a buried layer within the semiconductor substrate (2) and semiconductor region (10).

8. A method according to any preceding claim, further comprising the steps of:
before forming the masking layer (14), forming an insulating layer (12) over the semiconductor region (10);
forming the masking layer (14) over the insulating layer;
etching the masking layer (14) so that the openings (30-36) for defining the drain (52), source (50) and isolation regions of the JFET extend to the insulating layer;
forming a second masking layer (38) over the masking layer (14);
patterning and etching the second masking layer so as to provide at least one opening (46) that is coincident with but greater in size than a respective one of the openings in the masking layer (14);
wherein the step of forming an isolation region (48) comprises diffusing a dopant of the second conductivity type into the semiconductor region (10) through the at least one opening (46) in the second masking layer and the respective opening in the masking layer;
removing the second masking layer (38);
removing portions of the insulating layer (12) so as to extend the openings in the masking layer (14) to the semiconductor region (10);
wherein the step of forming the source and drain regions comprises implanting a dopant of the second conductivity type into the semiconductor region (10) through the extending openings; and
wherein the step of removing the masking layer (14) further comprises the step of removing the insulating layer (12).

9. A method of forming a depletion JFET and a bipolar transistor on a semiconductor substrate comprising the steps of:
providing a semiconductor substrate (2) having a semiconductor region (10) of a first conductivity type formed over the semiconductor substrate;
forming a masking layer (14) over the semiconductor region (10);
patterning and etching the masking layer (14) to form openings (30-36) in the masking layer, the openings for defining the drain (52) and source (50) and isolation regions (48) of the JFET and the base region (112) of the bipolar transistor;
forming an isolation region (48) and then forming the source (50) and drain (52) regions and the base region (112) each of a second conductivity type in the semiconductor region through the openings;
removing the masking layer and forming a first insulating layer (54) over the semiconductor region;
patterning and etching the first insulating layer to form first openings in the first insulating layer extending to the semiconductor region;
forming in the semiconductor region through the first openings in the first insulating layer a gate contact region (58) of the first conductivity type adjacent at least one of the source and drain regions and emitter and collector regions of the first conductivity type;
removing a portion of the first insulating layer;
patterning and etching the remaining portion of the first insulating layer to form second openings (68) in the first insulating layer to the semiconductor region, one of the second openings extending over the drain (52) and source (50) regions and the gate contact region (58), the other ones of the second openings defining oversize contact regions (134) for the bipolar transistor;
forming through the one of the second openings (68) in the first insulating layer a top gate region (59) of the first conductivity type in the semiconductor region adjacent a top surface of the semiconductor region;
forming a channel region (57) of the second conductivity type buried in the semiconductor region, the channel region extending between the source (50) and drain (52) regions; and
forming metal contacts to the source and drain regions and gate contact region and to the emitter, collector and base regions through the other ones of the second openings.
